Europäisches Patentamt

European Patent Office

Office européen des brevets

(11) Veröffentlichungsnummer: **0 486 101 A2**

# (12) EUROPÄISCHE PATENTANMELDUNG

(21) Anmeldenummer: **91202930.3**

(51) Int. Cl.5: **H04L 27/20**

(22) Anmeldetag: **12.11.91**

(30) Priorität: **16.11.90 DE 4036512**

(43) Veröffentlichungstag der Anmeldung:
**20.05.92 Patentblatt 92/21**

(84) Benannte Vertragsstaaten:
**CH DE ES FR GB IT LI**

(71) Anmelder: **Philips Patentverwaltung GmbH
Wendenstrasse 35 Postfach 10 51 49
W-2000 Hamburg 1(DE)**

(84) **DE**

(71) Anmelder: **N.V. Philips' Gloeilampenfabrieken
Groenewoudseweg 1**

NL-5621 BA Eindhoven(NL)

(84) **CH ES FR GB IT LI**

(72) Erfinder: **Koch, Wolfgang, Dr.-Ing.
Simmelberger Weg 29a
W-8501 Heroldsberg(DE)**
Erfinder: **Weith, Jürgen, Dipl.-Ing.
Kalchreuther Strasse 3
W-8501 Eckental(DE)**

(74) Vertreter: **Volmer, Georg et al
Philips Patentverwaltung GmbH
Wendenstrasse 35, Postfach 10 51 49
W-2000 Hamburg 1(DE)**

(54) **Digitale Schaltungsanordnung zur näherungsweisen Realisierung einer GMSK (Gaussian Minimum Shift Keying)-Modulation.**

(57) Die Erfindung bezieht sich auf eine digitale Schaltungsanordnung zur näherungsweisen Realisierung einer GMSK (Gaussian Minimium Shift Keying)-Modulation, bei der aus einer Folge von binären Eingangswerten mit einer linearen Filteranordnung (2) eine Folge von imaginären und eine Folge von reellen Ausgangswerten erzeugt wird. Ein Phasengenerator (1) gibt in Abhängigkeit zweiter aufeinanderfolgender binärer Eingangswerte die reellen Zahlen 1 oder -1 oder die imaginären Zahlen j oder -j als binär codierte Phasengeneratorwerte aus. In dem Phasengenerator werden bei Gleichheit von zwei aufeinanderfolgenden Eingangswerten die Zahlen in positiver Reihenfolge von 1 auf j oder von j auf -1 oder von -1 auf -j oder von -j auf 1 und bei Ungleichkeit von zwei aufeinanderfolgenden Eingangswerten in umgekehrter negativer Reihenfolge verändert. Die lineare Filteranordnung erhält die Phasengeneratorwerte.

FIG.1

Die Erfindung bezieht sich auf eine digitale Schaltungsanordnung zur näherungsweisen Realisierung einer GMSK (Gaussian Mininum Shift Keying)-Modulation, die eine lineare Filteranordnung zur Erzeugung einer Folge von imaginären und einer Folge von reellen Ausgangswerten aus einer Folge von binären Eingangswerten enthält.

Bei dem geplanten europäischen digitalen Mobilkommunikationssystem (GSM-Netz) werden die zu übertragenden digitalen Daten moduliert und als analoges Signal in einem Funk-Hochfrequenzkanal übertragen. Als Modulationsart wird die GMSK (Gaussian Minimum Shift Keying)-Modulation verwendet. Ein solcher GMSK-Modulator moduliert einen Strom von binären Eingangswerten $a_k$, welche jeweils einem Bit entsprechen. Das von dem GMSK-Modulator modulierte Ausgangssignal $y(t)$ läßt sich durch folgende mathematische Ausdrücke beschreiben:

$$y(t) = x_1(t) \exp (j\alpha \int_{-\infty}^{t} w(\tau)d\tau \qquad (1)$$

$$\text{mit } w(t) = x_2(t) * g_0(t) * p(T_B, t),$$

wobei $p(t_1, t_2) = 1$, wenn $|t_2| < t_1/2$ und

sonst $p(t_1, t_2) = 0$ ist,

$\alpha = \pi/2,$

$$g_0(t) = (1/\sqrt{2\pi}\,\sigma T_B) \exp (-t^2/(2\sigma^2 T_B^2)),$$

$\sigma = \sqrt{\ln(2)}/(\pi BT_B)$, $BT_B = 0{,}3$ ist,

und mit dem Trägersignal

$x_1(t) = \exp(j\omega_0 t)$

und mit

$$x_2(t) = \sum_{k=-\infty}^{\infty} b_k \, \delta_0(t - kT_B),$$

wobei $b_k = 2(a_k \oplus a_{k-1}) - 1$ ist.

Das Zeichen $\oplus$ beschreibt eine modulo-2-Addition, das Zeichen * ist das Faltungssymbol, $T_B$ beschreibt die Zeitdauer zwischen zwei aufeinanderfolgenden Eingangswerten $a_k$ und $\omega_0$ ist die Trägerfrequenz.

Die eingangs genannte Schaltungsanordnung zur GMSK-Modulation, die ein Ausgangssignal $y(t)$ erzeugt, ist aus der EP-A2-0 371 751 bekannt. Zur Erzeugung eines Stromes von reellen und imaginären Ausgangswerten enthält die bekannte Schaltungsanordnung zwei Speicherschaltungen. Die Adresseneingänge jeder Speicherschaltung sind mit jeweils drei Registern und einem Interpolationszähler verbunden. Der Interpolationszähler liefert jeder Speicherschaltung ein Taktsignal mit einer erhöhten Frequenz gegenüber der Frequenz des Taktsignales, mit dem die Eingangswerte in einen ersten Speicher eingelesen werden. Den Speicherschaltungen werden vom ersten Register die Eingangswerte, von einem zweiten Register die Phasenwerte der Eingangswerte und von einem dritten Register Werte zur Synchronisation geliefert. Durch die Speicherschaltungen wird ein nichtrekursives Filter, eine Integration, eine Berechnung von Sinus- und Kosinuswerten zur Erzeugung von imaginären und reellen Ausgangswerten und eine Non-Return-Zero (NRZ) -Codierung nachgebildet. Hiermit wird im wesentlichen das oben angegebene Ausgangssignal y(t) berechnet. Die reellen und imaginären Ausgangswerte werden jeweils einem Digital-Analog-Umsetzer und einem nachfolgenden Tiefpaß zugeführt.

Der Erfindung liegt die Aufgabe zugrunde, eine Schaltungsanordnung zur GMSK-Modulation zu schaffen, die einen geringeren Realisierungsaufwand aufweist.

Diese Aufgabe wird bei einer Schaltungsanordnung der eingangs genannten Art dadurch gelöst, daß ein Phasengenerator in Abhängigkeit zweier aufeinanderfolgender binärer Eingangswerte zur Ausgabe der reellen Zahlen 1 oder -1 oder der imaginären Zahlen j oder -j als binär codierte Phasengeneratorwerte vorgesehen ist,

daß der Phasengenerator bei Gleichheit von zwei aufeinanderfolgenden Eingangswerten zur Veränderung der Zahlen in positiver Reihenfolge von 1 auf j oder von j auf -1 oder von -1 auf -j oder von -j auf 1 und bei Ungleichheit von zwei aufeinanderfolgenden Eingangswerten zur Veränderung der Zahlen in umgekehrter negativer Reihenfolge vorgesehen ist und

daß die lineare Filteranordnung zum Empfang der Phasengeneratorwerte und zur Erzeugung der reellen und imaginären Ausgangswerte vorgesehen ist.

Die erfindungsgemäße Schaltungsanordnung läßt sich durch folgende mathematische Ausdrücke beschreiben:

$$\hat{y}(t) = h_0(t) * s_0(t) \qquad (2)$$

mit

$$s_0(t) = \sum_{k=-\infty}^{\infty} (-2a_k + 1)\, \delta_0(t - kT_B)\, \exp(j\pi t/(2T_B)),$$

wobei * das Faltungssymbol und $T_B$ die Zeitdauer zwischen zwei aufeinanderfolgenden Eingangswerten $a_k$ beschreibt. Es läßt sich zeigen, daS die Funktion y(t) annähernd der Funktion $\hat{y}(t)/x_1(t)$ entspricht. Die Fehler sind vernachlässigbar gering. Die Funktion $x_1(t)$ stellt das oben genannte Trägersignal dar. Nach Multiplikation der Funktion y(t) mit dem Trägersignal $x_1(t)$ ergibt sich das modulierte Ausgangssignal.

Der Phasengenerator, der die reellen Zahlen 1 oder -1 und die imaginären Zahlen j und -j ausgibt, stellt die zeitdiskrete Realisierung der Funktion $s_0(t)$ dar. Sind zwei aufeinanderfolgende Eingangswerte gleich, so gibt der Phasengenerator Phasengeneratorwerte ab, die sich von 1 auf j oder von j auf -1 oder von -1 auf -j oder von -j auf 1 verändern. Bei zwei aufeinanderfolgenden ungleichen Eingangswerten verändert sich der Phasengeneratorwert von j auf 1 oder von 1 auf -j oder von -j auf -1 oder von -1 auf j.

Die Phasengneratorwerte werden der linearen Filteranordnung zugeführt, die durch die Funktion $h_0(t) = h_0(lT)$ beschrieben wird, wobei T die Abtastperiode und $l = 1,..., L$ ist, und die reelle und imaginäre Ausgangswerte erzeugt. Diese lineare Filteranordnung kann aus zwei rekursiven oder nichtrekursiven Filtern bestehen. Ein Filter bildet den imaginären und das andere Filter den reellen Ausgangswert. Die Koeffizienten $h_l$ der Filter lassen sich nach verschiedenen Methoden bestimmen. Bei einer ersten Methode wird die lineare Filteranordnung nach Vorschriften im Frequenz- und Zeitbereich optimiert. Bei einer zweiten Methode wird für eine Quasizufallsfolge die Kreuzkorrelationsfunktion zwischen der Funktion (1) und der Folge der Eingangswerte $a_k$ bestimmt. Hiervon ausgehend werden die Koeffizienten der Filteranordnung berechnet. Bei einer dritten Methode wird das Signal y(t) der Funktion (1) für eine Folge von Eingangswerten $a_k$ für alle relevanten Bitkombinationen bestimmt. Danach werden die Folgen von Phasengeneratorwerten berechnet, die sich aus den Folgen der Eingangswerte ergeben. Es wird anschließend ein Gleichungssystem mit den Phasengeneratorwerten, den Filterkoeffizienten und den Ausgangswerten aufgestellt, die sich bei der Folge von Eingangswerten nach Funktion (1) ergeben. Zum Schluß wird das Gleichungssystem für die Filterkoeffizienten aufgelöst. Hierbei können Näherungsverfahren berücksichtigt werden, da sich die Koeffizienten oft nicht exakt bestimmen lassen.

Die lineare Filteranordnung muß also so entworfen werden, daß deren Ausgangszeitfunktion annähernd die Ausgangszeitfunktion ergibt, die sich aus Funktion (1) berechnen läßt. Eine solche Filteranordnung weist eine glockenförmige Übertragungsfunktion auf.

Vom Phasengenerator werden abwechselnd imaginäre und reelle Phasengeneratorwerte geliefert. Daher ist es nur wesentlich, daß die lineare Filteranordnung Vorzeicheninformationen erhält. Der Phasengenerator liefert also der linearen Filteranordnung als Phasengeneratorwert nur das Vorzeichenbit.

In einer Weiterbildung der Erfindung ist vorgesehen, daß die als nichtrekursives Filter ausgebildete lineare Filteranordnung eine Kette von Registern enthält, welche zum Durchlaufen der vom Phasengenerator zu liefernden Phasengeneratorwerte vorgesehen sind,

daß eine im Filter enthaltene Kombinationsschaltung zur Erzeugung von jeweils zwei Filterwerten aus dem von dem Phasengenerator zu liefernden Phasengeneratorwert und der Ausgangswerte der Register vorgesehen ist,

daß die Kombinationsschaltung zur Bildung eines ersten Filterwertes durch eine erste Wichtung des Phasengeneratorwertes und der Ausgangswerte der Register, die zum Erhalten eines die Kette durchlaufenden Wertes nach Durchlaufen von jeweils $(2n+1)$-Registern eingerichtet sind, wobei $n$ eine natürliche Zahl ist, und durch Summierung der ersten gewichteten Werte und zur Bildung eines zweiten Filterwertes durch eine zweite Wichtung der anderen Ausgangswerte und durch Summierung der zweiten gewichteten Werte vorgesehen ist und

daß eine im Filter enthaltene Schalteranordnung zur Zuführung der beiden Filterwerte und nach jeder Filterwertbildung abwechselnd zur Ausgabe der Filterwerte als reelle oder imaginäre Ausgangswerte vorgesehen ist. Bei dieser Weiterbildung wird zur Erzeugung der Ausgangswerte nur eine als nichtkursives Filter ausgebildete Filteranordnung verwendet. Diese weist zwei Ausgänge auf. Jeder Ausgang liefert abwechselnd einen imaginären und einen reellen Ausgangswert.

In einer ersten Ausführungsform für die Kombinationsschaltung ist vorgesehen, daß diese jeweils dem Eingang des ersten Registers der Kette der Register und jedem Ausgang der Register zugeordnete Multiplizierer, welche zur Multiplikation des Phasengeneratorwertes und der Ausgangswerte der Register mit Koeffizienten eingerichtet sind, einen ersten Addierer zur Bildung des ersten Filterwertes durch Summierung der ersten gewichteten Werte und einen zweiten Addierer zur Bildung des zweiten Filterwertes durch Summierung der zweiten gewichteten Werte enthält. Die Wichtung mit Koeffizienten wird bei dieser Ausführungsform mit Multiplizierern realisiert. Nach der Multiplikation werden die Filterwerte durch Addition der multiplizierten Werte gebildet.

Die reellen und imaginären Ausgangswerte müssen jeweils einen Digital-Analog-Umsetzer und jeweils einen Tiefpaß durchlaufen bevor sie nach Multiplikation mit dem Trägersignal in einem analogen Multiplizierer als moduliertes Ausgangssignal über eine Funkübertragungsstrecke gegeben werden. Jeder analoge Tiefpaß unterdrückt störende, gespiegelte Spektralanteile. Damit ein solcher analoger Tiefpaß auf einfache Weise ausgeführt werden kann, werden zwischen einem Taktintervall der Register weitere Filterwerte gebildet (Überabtastung). Hierdurch ergibt sich eine Streckung des Spektrums, so daß der Tiefpaß so ausgeführt werden kann, daß er eine flachere Flanke an der Grenzfrequenz aufweisen kann. Dies kann realisiert werden, indem die Multiplizierer jeweils während eines Taktintervalles der Register mehrmals zur Multiplikation des Phasengeneratorwertes und der Ausgangswerte der Register mit unterschiedlichen Koeffizienten zur Bildung von überabgetasteten ersten und zweiten Filterwerten vorgesehen sind.

Bei einer zweiten Ausführungsform für die Kombinationsschaltung ist vorgesehen, daß diese eine erste Steuerschaltung, einen ersten Koeffizientenspeicher und einen Akkumulator enthält,

daß die erste Steuerschaltung zeitlich hintereinander zur Zuführung des Phasengeneratorwertes und der Ausgangswerte der Register als Adressen für den ersten Koeffizientenspeicher zur Abgabe von Koeffizienten an den Akkumulator vorgesehen ist und

daß der Akkumulator nacheinander zum Empfang von Koeffizienten und des entsprechenden von der ersten Steuerschaltung zugeführten Vorzeichenbits und zur Bildung des ersten und zweiten Filterwertes vorgesehen ist. Hierbei wird dem Akkumulator jeweils zeitlich hintereinander ein Koeffizient vom ersten Koeffizientenspeicher zugeführt. Zuerst wird der erste Filterwert und anschließend der zweite Filterwert berechnet.

Bei dieser letztgenannten Ausführungsform läßt sich ebenfalls eine Überabtastung realieren. Dies kann realisiert werden, indem die erste Steuerschaltung während eines Taktintervalls der Register mehrmals zeitlich hintereinander zur Zuführung des Phasengeneratorwertes, der Ausgangswerte der Register und von einer Zeigeradresse zum ersten Koeffizientenspeicher vorgesehen ist,

daß die Zeigeradresse zur Ausgabe dient, wie oft während des Taktintervalls jeweils der Phasengeneratorwert und die Ausgangswerte des Registers als Adresse verwendet worden sind, und

daß der Akkumulator zur Bildung von überabgetasteten ersten und zweiten Filterwerten aus den Koeffizienten vorgesehen ist.

Bei einer dritten Ausführungsform ist vorgesehen, daß die Kombinationsschaltung eine zweite Steuerschaltung und einen zweiten und dritten Koeffizientenspeicher enthält, daß die zweite Steuerschaltung zur Lieferung des Phasengeneratorwertes und der Ausgangswerte der Register, die zur Bildung des ersten Filterwertes dienen, als Adressen für den zweiten Koeffizientenspeicher vorgesehen ist, daß der zweite Koeffizientenspeicher zur Ausgabe des ersten Filterwertes vorgesehen ist,

daß die zweite Steuerschaltung zur Lieferung der Ausgangswerte der Register, die zur Bildung des zweiten Filterwertes dienen, als Adresse für den dritten Koeffizientenspeicher vorgesehen ist, und daß der dritte Koeffizientenspeicher zur Ausgabe des zweiten Filterwertes vorgesehen ist. In den beiden Koeffizientenspeichern sind jeweils alle möglichen Ergebnisse für den ersten und zweiten Filterwert abgespeichert. Die zweite Steuerschaltung ruft jeweils durch Anlegen einer Adresse an den Koeffizientenspeicher das Ergebnis am Ausgang der Koeffizientenspeicher auf.

Bei dieser Ausführungsform können ebenfalls überabgetastete erste und zweite Filterwerte gebildet werden. Dies kann realisiert werden, indem die zweite Steuerschaltung während eines Taktintervalles der Register mehrmals zeitlich hintereinander zur Zuführung des Phasengeneratorwertes, von Ausgangswerten von Registern und einer Zeigeradresse zum zweiten Koeffizientenspeicher vorgesehen ist und zur Zuführung von Ausgangswerten von Registern und der Zeigeradresse zum dritten Koeffizientenspeicher vorgesehen ist,

daß die Zeigeradresse zur Ausgabe dient, wie oft während des Taktintervalles jeweils der Phasengeneratorwert und die Ausgangswerte der Register als Adresse verwendet worden sind, und

daß der zweite und dritte Koeffizientenspeicher zur Ausgabe von überabgetasteten ersten und zweiten Filterwerten vorgesehen sind.

Es hat sich bei praktischen Untersuchungen gezeigt, daß eine Schaltungsanordnung zur GMSK-Modulation mit genügender Genauigkeit realisiert werden kann, wenn die lineare Filteranordnung eine Kette von vier Registern und einer achtfachen Überabtastung enthält. Bei einer Kette von vier Registern können insgesamt 32 Bitkombinationen gebildet werden, die den Multiplizierern oder den jeweiligen Koeffizientenspeichern zugeführt werden. Bei der zweiten Ausführungsform der Register müssen maximal 40 Koeffizienten im Koeffizientenspeicher gespeichert werden. Bei der dritten Ausführungsform müssen im zweiten Koeffizientenspeicher 64 Ausgangswerte und im dritten Ausgangsspeicher 32 Ausgangswerte gespeichert sein. Die Anzahl der gespeicherten Ausgangswerte ist wesentlich geringer als die Anzahl der gespeicherten Ausgangswerte in der oben genannten, bekannten Schaltungsanordnung zur GMSK-Modulation.

In einer Ausführungsform für den Phasengenerator ist vorgesehen, daß in diesem ein EXKLUSIV-ODER-Gatter zum Erhalten der Eingangswerte und Werten von einem Eingangs-Register vorgesehen ist, daS das Eingangs-Register zum Empfang der Eingangswerte vorgesehen ist, und

daß ein Zähler zum Empfang des Ausgangssignals des EXKLUSIV-ODER-Gatters an seinem Zählrichtungseingang und zur Abgabe der Phasengeneratorwerte an seinen Zählerausgang vorgesehen ist.

Ausführungsbeispiele der Erfindung werden nachstehend anhand der Zeichnungen näher erläutert. Es zeigen:

Fig. 1 eine schematisch skizzierte Schaltungsanordnung zur näherungsweisen Realisierung einer GMSK-Modulation und

Fig. 2 bis 4 Ausführungsbeispiele einer in Fig. 1 verwendeten linearen Filteranordnung.

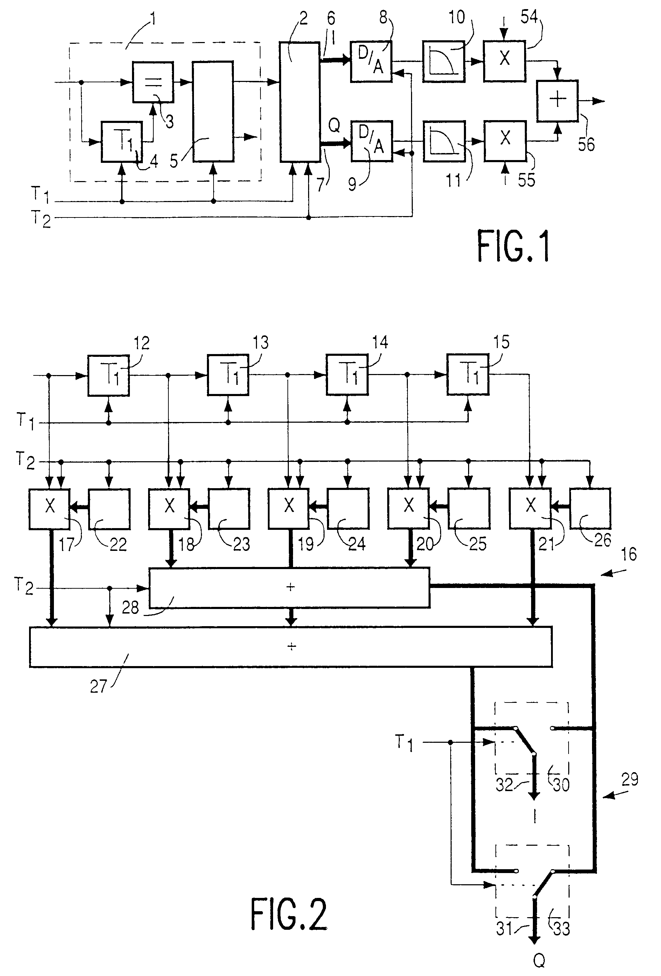

Die in Fig. 1 dargestellte Schaltungsanordnung zur näherungsweisen Realisierung einer GMSK-Modulation (GMSK = Gaussian Minimum Shift Keying) enthält einen Phasengenerator 1 und eine lineare Filteranordnung 2. Der Phasengenerator 1 umfaßt ein EXKLUSIV-ODER-Gatter 3, ein Eingangs-Register 4 und einen Zähler 5. Das EXKLUSIV-ODER-Gatter 3 und das Eingangs-Register 4 empfangen binäre Eingangswerte, die jeweils aus einem Bit bestehen. Der Ausgang des Eingangs-Registers 4 ist mit einem weiteren Eingang des EXKLUSIV-ODER-Gatters 3 verbunden. Der Ausgang des EXKLUSIV-ODER-Gatters 3 ist mit einem Zählrichtungseingang des Zählers 5 verbunden. Der Zähler 5 stellt einen Aufwärts-Abwärts-2-Bit-Zähler dar. Die 2-Bit-Werte die der Zähler 5 an seinem Ausgang abgibt, sollen die reellen Zahlen 1 oder -1 oder die imaginären Zahlen j oder -j repräsentieren. Ein Ausgang des Zählers 5 gibt das Vorzeichenbit an und der andere Ausgang, ob die Zahl reell oder imaginär ist. Sind zwei aufeinanderfolgende binäre Eingangswerte gleich, so verändert sich die Zahl am Ausgang des Phasengenerators 1 von j auf -1 oder von -1 auf -j oder von -j auf 1 oder von 1 auf j. Sind zwei aufeinanderfolgende binäre Eingangswerte unterschiedlich, so verändert sich die Zahl am Ausgang des Phasengenerators 1 von j auf 1 oder von 1 auf -j oder von -j auf -1 oder von -1 auf j.

Der nachfolgend angeordneten linearen Filteranordnung 2 wird als Phasengeneratorwert vom Phasengenerator 1 nur das Vorzeichenbit geliefert, da das andere Bit am Ausgang des Zählers 5 keine Information enthält. Die lineare Filteranordnung 2 wird durch ein nichtrekursives Filter realisiert, dessen Koeffizienten sich nach einem der oben angegebenen Entwurfsmethoden bestimmen lassen. Die lineare Filteranordnung 2, das Eingangs-Register 4 und der Zähler 5 erhalten noch ein Taktsignal $T_1$. Des weiteren erhält die lineare Filteranordnung 2 noch ein Taktsignal $T_2$, dessen Frequenz um den Faktor 8 größer ist als die Frequenz des Taktsignales $T_1$.

Die lineare Filteranordnung 2 weist zwei Ausgänge 6 und 7 auf. Der Ausgang 6 liefert eine Folge von imaginären und der Ausgang 7 eine Folge von reellen Ausgangswerten. In der linearen Filteranordnung 2 wird eine Überabtastung um den Faktor 8 realisiert, d.h. für einen Phasenwert ergeben sich acht imaginäre und acht reelle Ausgangswerte. Der Ausgang 6 der linearen Filteranordnung 2 ist mit einem Digital-Analog-Umsetzer 8 und der Ausgang 7 mit einem weiteren Digital-Analog-Umsetzer 9 verbunden. Beide Digital-Analog-Umsetzer 8 und 9 erhalten das Taktsignal $T_2$. Zur Unterdrückung höherer unerwünschter Spektralanteile ist jeweils der Ausgang jedes Digital-Analog-Umsetzers 8 und 9 mit einem Tiefpaß 10 und 11 verbunden. Der Ausgang des Tiefpasses 10 ist mit einem Multiplizierer 54 verbunden, der das analoge Ausgangssignal des Tiefpasses 10 mit einem Sinussignal multipliziert. Das Ausgangssignal des Tiefpasses 11 wird ebenfalls mit einem Sinussignal, jedoch gegenüber dem erstgenannten um 90° versetzt, in einem Multiplizierer 55 multipliziert. Die beiden Ausgangssignale der Multiplizierer 54 und 55 werden in einem Addierer 56 kombiniert und bilden das modulierte Ausgangssignal des Modulators.

Ein erstes Ausführungsbeispiel für die lineare Filteranordnung 2 ist in der Fig. 2 dargestellt. Die von dem Zähler 5 gelieferten Phasenwerte werden einer Kette von vier Registern 12 bis 15 zugeführt. Jedes der Register 12 bis 15 verzögert ein ihm zugeführtes Signal um einen Takt des Taktsignales $T_1$. Die Register 12 bis 15 erhalten ebenfalls das Taktsignal $T_1$.

Die Folge der Phasengeneratorwerte und die Folgen der Ausgangswerte der Register 12 bis 15 werden einer Kombinationsschaltung 16 zugeführt. Die Kombinationsschaltung 16 enthält fünf Multiplizierer 17 bis 21, den Multiplizierern 17 bis 21 zugeordnete Teil-Koeffizientenspeicher 22 bis 26, einen ersten Addierer 27 und einen zweiten Addierer 28. Die Folge der Phasengeneratorwerte erhält der Multiplizierer 17, dem Koeffizienten vom Teil-Koeffizientenspeicher 22 geliefert werden. Den Multiplizierern 18 bis 21 werden jeweils Koeffizienten von den Teil-Koeffizientenspeichern 23 bis 26 geliefert. Die Folge der Ausgangswerte des Registers 12 werden dem Multiplizierer 18, die Folge der Ausgangswerte des Registers 13 dem Multiplizierer 19, die Folge der Ausgangswerte des Registers 14 dem Multiplizierer 20 und die Folge der Ausgangswerte des Registers 15 dem Multiplizierer 21 geliefert. Jeder Phasengeneratorwert und jeder Ausgangswert der Register 12 bis 15 werden zeitlich hintereinander jeweils mit acht Koeffizienten multipliziert. Hierdurch wird eine Überabtastung um den Faktor 8 realisiert. Zur Steuerung der Reihenfolge der Koeffizientenzuführung zu den jeweiligen Multiplizierern 17 bis 21 enthält noch jeder Teil-Koeffizientenspeicher 22 bis 26 einen Steuerungsteil. Folgende Koeffizienten sind in den Teil-Koeffizientenspeichern 22 bis 26 gespeichert:

$$
\begin{aligned}
h1 &= &&= 0.00000174392735 \\
h2 &= h40 &&= 0.00000984207507 \\
h3 &= h39 &&= 0.00004735484536 \\
h4 &= h38 &&= 0.00019512354117 \\
h5 &= h37 &&= 0.00069421355724 \\
h6 &= h36 &&= 0.00215498093580 \\
h7 &= h35 &&= 0.00588390228783 \\
h8 &= h34 &&= 0.01424572656741 \\
h9 &= h33 &&= 0.03082029075074 \\
h10 &= h32 &&= 0.06005558046161 \\
h11 &= h31 &&= 0.10630369900764 \\
h12 &= h30 &&= 0.17250149731516 \\
h13 &= h29 &&= 0.25899226901518 \\
h14 &= h28 &&= 0.36286856193896 \\
h15 &= h27 &&= 0.47796533588624 \\
h16 &= h26 &&= 0.59555317796627 \\
h17 &= h25 &&= 0.70576086716994 \\
h18 &= h24 &&= 0.79946004620151 \\
h19 &= h23 &&= 0.86987654832661 \\
h20 &= h22 &&= 0.91314516745915 \\
h21 & &&= 0.92768719469259
\end{aligned}
$$

In dem Teil-Koeffizientenspeicher 22 sind die Koeffizienten h1 bis h8, in dem Teil-Koeffizientenspeicher 23 die Koeffizienten h9 bis h16, in dem Teil-Koeffizientenspeicher 24 die Koeffizienten h17 bis h24, in dem Teil-Koeffizientenspeicher 25 die Koeffizienten h25 bis h32 und in dem Teil-Koeffizientenspeicher 26 die Koeffizienten h33 bis h40 abgelegt.

Im ersten Addierer 27 werden die mit den Koeffizienten des Teil-Koeffizientenspeichers 16 gewichteten Phasengeneratorwerte, die mit den Koeffizienten des Teil-Koeffizientenspeichers 24 gewichteten Ausgangswerte des Registers 13 und die mit den Koeffizienten des Teil-Koeffizientenspeichers 26 gewichteten Ausgangswerte des Registers 15 addiert. Die mit den Koeffizienten des Teil-Koeffizientenspeichers 23 gewichteten Ausgangswerte des Registers 12 und die mit den Koeffizienten des Teil-Koeffizientenspeichers 25 gewichteten Ausgangswerte des Registers 14 werden in dem zweiten Addierer 28 addiert. Der von dem ersten Addierer 27 gebildete erste Filterwert und der von dem zweiten Addierer 28 gebildete zweite Filterwert werden einer Schalteranordnung 29 zugeführt, die einen ersten Schalter 30 und einen zweiten Schalter 33 enthält. Der erste Schalter 30 verbindet den Ausgang des ersten Addierers 27 oder den Ausgang des zweiten Addierers 28 mit seinem Ausgang 32. Der zweite Schalter 33 verbindet ebenfalls den Ausgang des ersten Addierers 27 oder den Ausgang des zweiten Addierers 28 mit seinem Ausgang 31. Die beiden Schalter sind dabei gegensätzlich geschaltet. Wenn der Ausgang 32 des ersten Schalters 30 mit dem Ausgang des ersten Addierers 27 verbunden ist, ist der Ausgang 31 des zweiten Schalters 33 mit dem Ausgang des zweiten Addierers 28 verbunden und umgekehrt.

Es sei noch bemerkt, daß den Multiplizierern 17 bis 21, den Teil-Koeffizientenspeichern 22 bis 26, dem ersten Addierer 27, dem zweiten Addierer 28 und den Schaltern 30 und 33 das Taktsignal $T_1$ zugeführt wird.

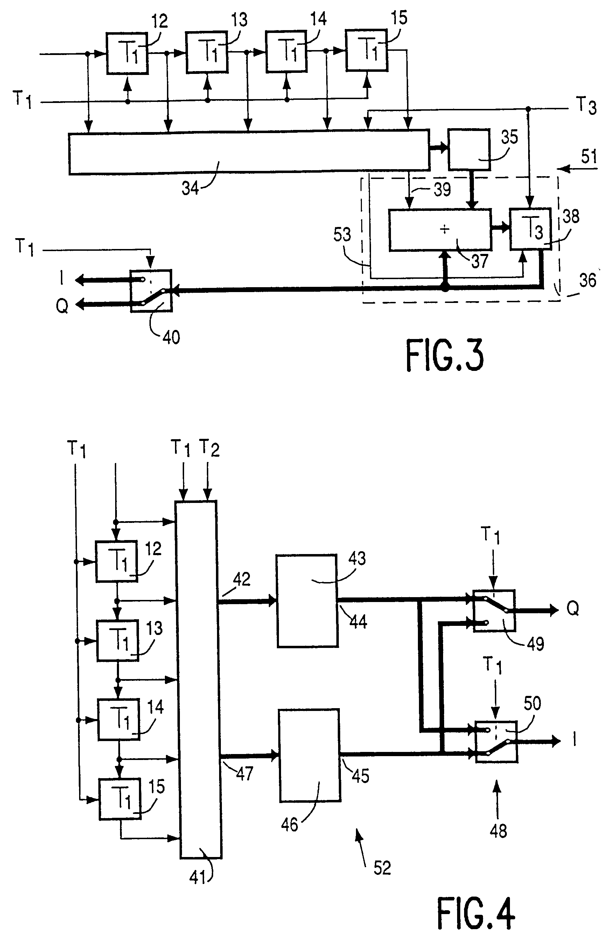

Ein weiteres Ausführungsbeispiel der linearen Filteranordnung 2 ist in Fig. 3 dargestellt. Dieses enthält ebenfalls die Kette der Register 12 bis 15, die jeweils das Taktsignal $T_1$ erhalten. Die Folge der Phasengeneratorwerte und die Folgen der Ausgangswerte der Register 12 bis 15 werden einer ersten Steuerschaltung 34 zugeführt. Die erste Steuerschaltung 34 liefert an einen ersten Koeffizientenspeicher 35 eine Anzahl von Adressen. Der erste Koeffizientenspeicher 35 liefert in Abhängigkeit von den Adressen Koeffizienten an einen Akkumulator 36, der aus einem Addierer 37 und einem Akkumulator-Register 38 besteht. Des weiteren wird dem Addierer 37 über eine Leitung 39 noch ein Vorzeichen von der ersten Steuerschaltung 34 zugeführt. Der Ausgang des Addierers 37 ist mit dem Akkumulator-Register 38 verbunden, dessen Ausgang an einen weiteren Eingang des Addierers 37 und an eine Schalteranordnung 40 angeschlossen ist.

In dem ersten Koeffizientenspeicher 35 sind alle vierzig Koeffizienten h1 bis h40 abgespeichert, mit denen der Phasengeneratorwert und die Ausgangswerte der Register 12 bis 15 multipliziert werden. Die Bildung eines ersten Filterwertes wird auf folgende Weise durchgeführt. Nach Einlesen von neuen Werten in die Register 12 bis 15 wird in der ersten Steuerschaltung 34 ein erster Zeiger auf einen Anfangswert gesetzt. Dieser Zeiger liefert eine Zeigeradresse zusammen mit einer Hauptadresse an den ersten Koeffizientenspeicher 35. Die Hauptadresse kennzeichnet zuerst den Phasengeneratorwert. Der von dem ersten Koeffizientenspeicher 35 zuerst ausgegebene Koeffizient ist der Koeffizient h1. Dieser Koeffizient h1 wird zusammen mit dem Vorzeichen des Phasengeneratorwertes im Akkumulator-Register 38 abgespeichert. Als nächstes wird nur die Hauptadresse geändert, die den Ausgangswert des Registers 13 kennzeichnet. Der erste Koeffizientenspeicher 35 gibt dann den Koeffizienten h17 und das Vorzeichen des Ausgangswertes des Registers 13 an den Addierer 37, in dem der Speicherinhalt des Akkumulator-Registers 38 mit dem zugeführten Koeffizienten und dem Vorzeichen verknüpft wird. Das Ergebnis wird im Akkumulator-Register 38 gespeichert. Die nächste Hauptadresse kennzeichnet den Ausgangswert des Registers 15. Der erste Koeffizientenspeicher 35 führt daher den Koeffizienten h33 dem Akkumulator zu, der nach erfolgter Addition einen ersten Filterwert bildet, der der Schalteranordnung 40 zugeführt wird.

Zur Bildung des zweiten Filterwertes wird zuerst die Hauptadresse geändert. Nun kennzeichnet die Hauptadresse den Ausgangswert des Registers 12. Der erste Koeffizientenspeicher 35 gibt den Koeffizienten h9 ab, der im Akkumulator-Register 38 gespeichert wird. Vorher wurde durch einen Löschbefehl über eine Löschleitung 53 von der ersten Steuerschaltung 34 das Akkumulator-Register 38 auf einen Anfangswert gesetzt. Anschließend wird eine Hauptadresse gebildet, die den Ausgangswert des Registers 14 kennzeichnet. Der erste Koeffizientenspeicher 35 liefert daraufhin den Koeffizienten h25, mit dem der Inhalt des Akkumulator-Registers 38 verknüpft wird. Auch bei der Bildung des zweiten Filterwertes wird jedesmal das Vorzeichen der Ausgangswerte der Register 12 und 14 dem Addierer 37 geliefert. Nach der Bildung des ersten und zweiten Filterwertes wird die Zeigeradresse um eine Einheit erhöht, so daß nachfolgend für die Bildung des zweiten Filterwertes die Koeffizienten h2, h18 und h34 dem Akkumulator 36 zugeführt werden können. Dies wird mit dem gleichen Phasengeneratorwert und den gleichen Ausgangswerten der Register 12 bis 15 achtmal durchgeführt.

Der ersten Steuerschaltung 34 und dem Akkumulator-Register 38 wird noch ein Taktsignal $T_3$ zugeführt, dessen Frequenz um das Vierzigfache höher ist, als die Frequenz des Taktsignales $T_1$. Die erste Steuerschaltung 34, der erste Koeffizientenspeicher 35 und der Akkumulator 36 sind Bestandteile einer Kombinationsschaltung 51.

Die Schalteranordnung 40 enthält einen Umschalter, der von einem Taktsignal $T_1$ gesteuert wird. An den beiden Ausgängen der Schalteranordnung 40 sind die reellen und imaginären Ausgangswerte abzunehmen.

Ein drittes Ausführungsbeispiel der linearen Filteranordnung 2 zeigt Fig. 4. Der Phasengeneratorwert und die Ausgangswerte der Register 12 bis 15, die das Taktsignal $T_1$ erhalten werden einer zweiten Steuerschaltung 41 zugeführt, die die beiden Taktsignale $T_1$ und $T_2$ erhält und die ebenso wie ein zweiter Koeffizientenspeicher 43 und ein dritter Koeffizientenspeicher 46 Bestandteil einer Kombinationsschaltung 52 sind. Ein erster Ausgang 42 der zweiten Steuerschaltung 41 ist mit dem zweiten Koeffizientenspeicher 43 verbunden, dessen Ausgang 44 den ersten Filterwert liefert. Den zweiten Filterwert liefert ein Ausgang 45 des dritten Koeffizientenspeichers 46, dessen Eingang mit einem zweiten Ausgang 47 der zweiten Steuerschaltung 41 verbunden ist. Die Adressen, die von den Ausgängen 42 und 47 der zweiten Steuerschaltung 41 geliefert werden, bestehen aus einer Haupt- und Zeigeradresse. Die Hauptadresse, die zum Ausgang 42 gegeben wird, besteht aus dem Phasengeneratorwert und den Ausgangswerten der Register 13 und 15. Die Hauptadresse, die am Ausgang 47 abgegeben wird, besteht aus den Ausgangswerten der Register 12 und 14. Die Zeigeradressen bestehen aus einer Zahl zwischen 1 und 8 und kennzeichnen das wievielte Mal eine Hauptadresse dem zweiten oder dritten Koeffizientenspeicher 43 oder 46 geliefert worden ist. Im zweiten Koeffizientenspeicher 43 sind alle Ergebnisse abgespeichert, die der erste Filterwert annehmen kann. Im dritten Koeffizientenspeicher 47 sind alle Ergebnisse abgespeichert, die der zweite Filterwert annehmen kann.

Mit dem Ausgang 44 des zweiten Koeffizientenspeichers 43 und mit dem Ausgang 45 des dritten Koeffizientenspeicher 46 ist noch eine Schalteranordnung 48 verbunden, die einen ersten Umschalter 49 und einen zweiten Umschalter 50 enthält. Der Ausgang 44 ist mit jeweils einem ersten Eingang der Umschalter 49 und 50 und der Ausgang 45 mit jeweils einem zweiten Eingang der Umschalter 49 und 50 verbunden. Am Ausgang des Umschalters 49 liegt der reelle Ausgangswert und am Ausgang des Umschalters 50 der imaginäre Ausgangswert an. Wenn der Umschalter eine Verbindung seines Ausganges mit dem Ausgang 44 des zweiten Koeffizientenspeichers 43 herstellt, ist der Ausgang des Umschalters 50 mit dem Ausgang 45 des dritten Koeffizientenspeichers 46 verbunden. Beide Umschalter 49 und 50 wechseln gleichzeitig ihre Stellung. Das Taktsignal $T_2$ wird den beiden Umschaltern 49 und 50 noch zugeführt.

**Patentansprüche**

1. Digitale Schaltungsanordnung zur näherungsweisen Realisierung einer GMSK (Gaussian Mininum Shift Keying)-Modulation, die eine lineare Filteranordnung (2) zur Erzeugung einer Folge von imaginären und einer Folge von reellen Ausgangswerten aus einer Folge von binären Eingangswerten enthält,
   dadurch gekennzeichnet,
   daß ein Phasengenerator (1) in Abhängigkeit zweier aufeinanderfolgender binärer Eingangswerte zur Ausgabe der reellen Zahlen 1 oder -1 oder der imaginären Zahlen j oder -j als binär codierte Phasengeneratorwerte vorgesehen ist, daß der Phasengenerator bei Gleichheit von zwei aufeinanderfolgenden Eingangswerten zur Veränderung der Zahlen in positiver Reihenfolge von 1 auf j oder von j auf -1 oder von -1 auf -j oder von -j auf 1 und bei Ungleichheit von zwei aufeinanderfolgenden Eingangswerten zur Veränderung der Zahlen in umgekehrter negativer Reihenfolge vorgesehen ist und daß die lineare Filteranordnung (2) zum Empfang der Phasengeneratorwerte und zur Erzeugung der reellen und imaginären Ausgangswerte vorgesehen ist.

2. Digitale Schaltungsanordnung nach Anspruch 1,
   dadurch gekennzeichnet,
   daß der Phasengenerator (1) nur zur Lieferung des Vorzeichenbits als Phasengeneratorwert für die lineare Filteranordnung (2) vorgesehen ist.

3. Digitale Schaltungsanordnung nach Anspruch 2,
   dadurch gekennzeichnet,
   daß die als nichtrekursives Filter ausgebildete lineare Filteranordnung (2) eine Kette von Registern (12 bis 15) enthält, welche zum Durchlaufen der vom Phasengenerator (1) zu liefernden Phasengeneratorwerte vorgesehen sind, daß eine im Filter enthaltene Kombinationsschaltung (16, 51, 52) zur Erzeugung von jeweils zwei Filterwerten aus dem von dem Phasengenerator zu liefernden Phasengeneratorwert und der Ausgangswerte der Register vorgesehen ist, daß die Kombinationsschaltung zur Bildung eines ersten Filterwertes durch eine erste Wichtung des Phasengeneratorwertes und der Ausgangswerte der Register, die zum Erhalten eines die Kette durchlaufenden Wertes nach Durchlaufen von jeweils (2n + 1)-Registern eingerichtet sind, wobei n eine natürliche Zahl ist, und durch Summierung der ersten gewichteten Werte und zur Bildung eines zweiten Filterwertes durch eine zweite Wichtung der anderen Ausgangswerte und durch Summierung der zweiten gewichteten Werte vorgesehen ist und daß eine im Filter enthaltene Schalteranordnung (29, 40, 48) zur Zuführung der beiden Filterwerte und nach jeder Filterwertbildung abwechselnd zur Ausgabe der Filterwerte als reelle oder imaginäre Ausgangswerte vorgesehen ist.

4. Digitale Schaltungsanordnung nach Anspruch 3,
   dadurch gekennzeichnet,
   daß die Kombinationsschaltung (16) jeweils dem Eingang des ersten Registers (12) der Kette der Register und jedem Ausgang der Register (12 bis 15) zugeordnete Multiplizierer (17 bis 21), welche zur Multiplikation des Phasengeneratorwertes und der Ausgangswerte der Register mit Koeffizienten eingerichtet sind, einen ersten Addierer (27) zur Bildung des ersten Filterwertes durch Summierung der ersten gewichteten Werte und einen zweiten Addierer (28) zur Bildung des zweiten Filterwertes durch Summierung der zweiten gewichteten Werte enthält.

**5.** Digitale Schaltungsanordnung nach Anspruch 4,
dadurch gekennzeichnet,
daß die Multiplizierer jeweils während eines Taktintervalles der Register (12 bis 15) mehrmals zur Multiplikation des Phasengeneratorwertes und der Ausgangswerte der Register mit unterschiedlichen Koeffizienten zur Bildung von überabgetasteten ersten und zweiten Filterwerten vorgesehen sind.

**6.** Digitale Schaltungsanordnung nach Anspruch 3,
dadurch gekennzeichnet,
daß die Kombinationsschaltung (51) eine erste Steuerschaltung (34), einen ersten Koeffizientenspeicher (35) und einen Akkumulator (36) enthält,
daß die erste Steuerschaltung zeitlich hintereinander zur Zuführung des Phasengeneratorwertes und der Ausgangswerte der Register (12 bis 15) als Adressen für den ersten Koeffizientenspeicher zur Abgabe von Koeffizienten an den Akkumulator vorgesehen ist und
daß der Akkumulator nacheinander zum Empfang von Koeffizienten und des entsprechenden von der ersten Steuerschaltung zugeführten Vorzeichenbits und zur Bildung des ersten und zweiten Filterwertes vorgesehen ist.

**7.** Digitale Schaltungsanordnung nach Anspruch 6,
dadurch gekennzeichnet,
daß die erste Steuerschaltung (34) während eines Taktintervalls der Register (12 bis 15) mehrmals zeitlich hintereinander zur Zuführung des Phasengeneratorwertes, der Ausgangswerte der Register und von einer Zeigeradresse zum ersten Koeffizientenspeicher (35) vorgesehen ist,
daß die Zeigeradresse zur Ausgabe dient, wie oft während des Taktintervalls jeweils der Phasengeneratortorwert und die Ausgangswerte des Registers als Adresse verwendet worden sind, und
daß der Akkumulator (36) zur Bildung von überabgetasteten ersten und zweiten Filterwerten aus den Koeffizienten vorgesehen ist.

**8.** Digitale Schaltungsanordnung nach Anspruch 3,
dadurch gekennzeichnet,
daß die Kombinationsschaltung (52) eine zweite Steuerschaltung (41) und einen zweiten und dritten Koeffizientenspeicher (43, 46) enthält,
daß die zweite Steuerschaltung zur Lieferung des Phasengeneratorwertes und der Ausgangswerte der Register (13, 15), die zur Bildung des ersten Filterwertes dienen, als Adressen für den zweiten Koeffizientenspeicher vorgesehen ist,
daß der zweite Koeffizientenspeicher zur Ausgabe des ersten Filterwertes vorgesehen ist,
daß die zweite Steuerschaltung zur Lieferung der Ausgangswerte der Register (12, 14), die zur Bildung des zweiten Filterwertes dienen, als Adresse für den dritten Koeffizientenspeicher vorgesehen ist, und
daß der dritte Koeffizientenspeicher zur Ausgabe des zweiten Filterwertes vorgesehen ist.

**9.** Digitale Schaltungsanordnung nach Anspruch 8,
dadurch gekennzeichnet,
daß die zweite Steuerschaltung (41) während eines Taktintervalles der Register (12 bis 15) mehrmals zeitlich hintereinander zur Zuführung des Phasengeneratorwertes, von Ausgangswerten von Registern und einer Zeigeradresse zum zweiten Koeffizientenspeicher (43) vorgesehen ist und zur Zuführung von Ausgangswerten von Registern und der Zeigeradresse zum dritten Koeffizientenspeicher (46) vorgesehen ist,
daß die Zeigeradresse zur Ausgabe dient, wie oft während des Taktintervalles jeweils der Phasengeneratorwert und die Ausgangswerte der Register als Adresse verwendet worden sind, und
daß der zweite und dritte Koeffizientenspeicher zur Ausgabe von überabgetasteten ersten und zweiten Filterwerten vorgesehen sind.

**10.** Digitale Schaltungsanordnung nach einem der Ansprüche 3 bis 9,
dadurch gekennzeichnet,
daß die lineare Filteranordnung (2) eine Kette von vier Registern (12 bis 15) enthält.

**11.** Digitale Schaltungsanordnung nach einem der vorhergehenden Ansprüche,
dadurch gekennzeichnet,
daß in dem Phasengenerator (1) ein EXKLUSIV-ODER-Gatter (3) zum Erhalten der Eingangswerte und Werten von einem Eingangs-Register (4) vorgesehen ist,
daß das Eingangs-Register zum Empfang der Eingangswerte vorgesehen ist, und
daß ein Zähler (5) zum Empfang des Ausgangssignals des EXKLUSIV-ODER-Gatters an seinem Zählrichtungseingang und zur Abgabe der Phasengeneratorwerte an seinen Zählerausgang vorgesehen ist.

FIG.1

FIG.2

FIG.3

FIG.4